# DEMANDE DE BREVET EUROPEEN

(11) **EP 3 556 911 A1**
(43) Date de publication de la demande: **23.10.2019**
(21) Numéro de dépôt: 18168168.5
(22) Date de dépôt: 19.04.2018
(51) Int. Cl.: C30B 29/04, C30B 29/20, C30B 33/00, C23C 18/14, B23K 26/53, C03C 23/00

(54) **PROCÉDÉ DE STRUCTURATION D'UN MOTIF DÉCORATIF OU TECHNIQUE DANS UN OBJET RÉALISÉ EN UN MATÉRIAU AMORPHE, SEMI-CRISTALLIN OU CRISTALLIN AU MOINS PARTIELLEMENT TRANSPARENT**

(71) Demandeur: Comadur S.A., 2400 Le Locle (CH)
(72) Inventeur: Boulmay, Alexis, 25500 Morteau (FR); Vuille, Pierry, 2338 Les Emibois (CH); Meier, Julien, 2000 Neuchâtel (CH); Tortora, Pierpasquale, 2000 Neuchâtel (CH)
(74) Mandataire: ICB SA

(57) **Abrégé**

L'invention concerne un procédé de structuration d'un motif décoratif ou technique (22, 60) dans l'épaisseur d'un objet réalisé en un matériau amorphe, semi-cristallin ou cristallin au moins partiellement transparent, l'objet réalisé en un matériau au moins partiellement transparent comprenant une surface supérieure (18a) et une surface inférieure (18b) qui s'étend à distance de la surface supérieure (18a), le procédé comprenant l'étape qui consiste à munir l'une au moins des surfaces supérieure (18a) ou inférieure (18b) de l'objet réalisé en un matériau au moins partiellement transparent d'un masque (24) qui définit au moins une ouverture (25) dont le contour correspond au profil du motif décoratif ou technique (22, 60) que l'on souhaite structurer, le masque (24) recouvrant la au moins une surface supérieure (18a) ou inférieure (18b) de l'objet réalisé en un matériau au moins partiellement transparent aux endroits qui ne doivent pas être structurés, le procédé comprenant également l'étape qui consiste à structurer le motif décoratif ou technique (22, 60) au moyen d'un faisceau d'ions (14) mono- ou multichargés à travers la au moins une ouverture (25) du masque (24), les propriétés mécaniques du masque (24) étant suffisantes pour empêcher les ions du faisceau d'ions (14) d'attaquer la au moins une surface supérieure (18a) ou inférieure (18b) de l'objet réalisé en un matériau au moins partiellement transparent aux endroits où cette surface supérieure (18a) ou inférieure (18b) est recouverte par le masque (24).

## Description

### Domaine technique de l'invention

La présente invention concerne un procédé de structuration d'un motif décoratif ou technique dans l'épaisseur d'un objet réalisé en un matériau amorphe, semi-cristallin ou cristallin au moins partiellement transparent. La présente invention concerne tout particulièrement un procédé de structuration au moyen d'un faisceau d'ions mono- ou multichargés.

### Arrière-plan technologique de l'invention

Il est connu de graver un motif décoratif au moyen d'un faisceau laser dans l'épaisseur d'un objet réalisé en un matériau transparent amorphe ou cristallin. Pour cela, on utilise un laser puissant dont le faisceau va être focalisé au moyen d'une lentille afin de créer une succession de points aux endroits voulus à l'intérieur de l'objet transparent. La lentille permet de concentrer la lumière cohérente issue du laser sur une très petite surface, ce qui permet d'atteindre des valeurs de puissance optique qui dépassent le seuil de dommage et qui sont suffisantes pour créer dans l'objet transparent des microfissures. Ces microfissures d'une dimension typique de 50 à 150 micromètres correspondent aux endroits où le faisceau laser a été focalisé et où la matière a fondu sous l'effet de l'apport de chaleur. Ces microfissures agissent comme autant de centres de diffusion de la lumière ambiante, ce qui permet de les révéler au regard de l'observateur. Il est ainsi possible de graver dans l'épaisseur d'un objet réalisé en un matériau transparent un réseau de points qui va former un motif selon deux dimensions. Pour réaliser une gravure en trois dimensions, il est possible de superposer plusieurs réseaux de points à deux dimensions de manière si précise que le motif résultant donne l'impression d'avoir été gravé d'un seul bloc.

L'avantage de la technique brièvement décrite ci-dessus est de permettre de réaliser des motifs à deux ou trois dimensions dans un objet réalisé en un matériau transparent tel qu'un objet en verre ou un objet en polyméthacrylate de méthyle (PMMA). Ces motifs peuvent avoir une fonction technique ou une fonction esthétique. Dans le domaine des produits grand public, on connaît notamment les objets réalisé en un matériau transparent dans lesquels on vient, à partir du fichier numérique d'une photographie, graver par exemple la reproduction du visage d'une personne. De tels produits connaissent un succès certain auprès des consommateurs. L'un des principaux inconvénients de cette technique de gravure est néanmoins le temps souvent très long nécessaire pour graver les motifs dans l'objet réalisé en un matériau transparent qui rend son utilisation dans le domaine industriel problématique.

### Résumé de l'invention

La présente invention a pour but de remédier aux problèmes susmentionnés ainsi qu'à d'autres encore en procurant un procédé de structuration d'un motif dans l'épaisseur d'un objet réalisé en un matériau au moins partiellement transparent qui soit notamment rapide et facilement automatisable.

A cet effet, la présente invention concerne un procédé de structuration d'un motif décoratif ou technique dans l'épaisseur d'un objet réalisé en un matériau amorphe, semi-cristallin ou cristallin au moins partiellement transparent, l'objet réalisé en un matériau au moins partiellement transparent comprenant une surface supérieure et une surface inférieure qui s'étend à distance de la surface supérieure, le procédé comprenant l'étape qui consiste à munir l'une au moins des surfaces supérieure ou inférieure de l'objet réalisé en un matériau au moins partiellement transparent d'un masque qui définit au moins une ouverture dont le contour correspond au profil du motif décoratif ou technique que l'on souhaite structurer, le masque recouvrant la au moins une surface supérieure ou inférieure de l'objet réalisé en un matériau au moins partiellement transparent aux endroits qui ne doivent pas être structurés, le procédé comprenant également l'étape qui consiste à structurer le motif décoratif ou technique au moyen d'un faisceau d'ions mono- ou multichargés à travers la au moins une ouverture du masque, les propriétés mécaniques du masque étant suffisantes pour empêcher les ions du faisceau d'ions d'attaquer la au moins une surface supérieure ou inférieure de l'objet réalisé en un matériau au moins partiellement transparent aux endroits où cette surface est recouverte par le masque.

Selon un mode particulier de mise en oeuvre du procédé selon l'invention, le faisceau d'ions mono- ou multichargés est produit par une source d'ions mono- ou multichargés du type à résonance cyclotron électronique ECR.

Selon un autre mode particulier de mise en oeuvre du procédé selon l'invention, l'objet au moins partiellement transparent est réalisé en saphir, en rubis ou en diamant, de préférence de synthèse.

Selon encore un autre mode particulier de mise en oeuvre du procédé selon l'invention, l'objet au moins partiellement transparent est réalisé en un matériau organique semi-cristallin.

Selon encore un autre mode particulier de mise en oeuvre du procédé selon l'invention, l'objet au moins partiellement transparent est réalisé en verre minéral ou en un matériau organique amorphe.

Selon encore un autre mode particulier de mise en oeuvre du procédé selon l'invention, le masque est déposé sur l'une au moins des surfaces supérieure et inférieure de l'objet réalisé en un matériau au moins partiellement transparent :
- soit par dépôt sélectif tel que l'impression par jet d'encre d'un matériau de masquage aux endroits où le masque doit recouvrir celle des surfaces supérieure et/ou inférieure sur laquelle il est structuré ;
- soit par dépôt d'une couche d'un matériau de masquage sur la totalité de celle des surfaces supérieure et/ou inférieure sur laquelle le masque doit être structuré, puis ablation de la couche de masquage aux endroits où celle des surfaces supérieure et/ou inférieure doit être structurée.

Selon encore un autre mode particulier de mise en oeuvre du procédé selon l'invention, la couche de masquage est ablatée au moyen d'un faisceau laser.

Selon encore un autre mode particulier de mise en oeuvre du procédé selon l'invention, le matériau de masquage est une résine sensible au rayonnement ultraviolet qui est structurée au moyen d'une source UV.

La présente invention concerne également un objet réalisé en un matériau amorphe, semi-cristallin ou cristallin au moins partiellement transparent et structuré conformément au procédé selon l'invention. Cet objet peut notamment être une glace, un cadran ou une lunette pour une pièce d'horlogerie telle qu'une montre-bracelet, une carrure ou un fond de boîte de montre, une couronne de remontage ou une tête de bouton-poussoir pour un mouvement d'horlogerie, un maillon de bracelet pour une montre ou un bijou ou bien un pont pour un mouvement d'horlogerie.

La présente invention concerne également un objet portable, notamment une boîte de montre, comprenant au moins un élément choisi dans le groupe formé par une glace, un cadran, un pont et un fond, ce au moins un élément étant réalisé en un matériau amorphe, semi-cristallin ou cristallin au moins partiellement transparent et structuré conformément au procédé selon l'invention, cet élément comprenant au moins une surface supérieure et au moins une surface inférieure reliées entre elles par une tranche, l'objet portable comprenant également une source de lumière, la source de lumière étant agencée de façon à éclairer l'élément par sa surface inférieure ou par sa tranche.

Grâce à ces caractéristiques, la présente invention procure un procédé qui permet de structurer de manière sélective un motif technique ou décoratif tridimensionnel dans un objet réalisé en un matériau au moins partiellement transparent au moyen d'un faisceau d'ions mono- ou multichargés. Au sens de l'invention, on entend par ions mono-chargés des ions dont le degré d'ionisation est égal à +1, et par ions multichargés des ions dont le degré d'ionisation est supérieur à +1. Le faisceau d'ions peut comprendre des ions présentant tous le même degré d'ionisation, ou peut résulter d'un mélange d'ions présentant des degrés d'ionisation différents.

En bombardant à travers un masque une surface d'un objet réalisé en un matériau au moins partiellement transparent au moyen d'un faisceau d'ions, il est possible de structurer dans cet objet un motif technique ou décoratif tridimensionnel depuis la surface et jusqu'à une certaine profondeur. En effet, en venant frapper l'objet réalisé en un matériau au moins partiellement transparent, les ions du faisceau d'ions pénètrent dans l'objet et créent des défauts du type cavités ou lacunes à partir d'une très faible distance depuis la surface de cet objet, typiquement de l'ordre de 10 à 15 nanomètres, et ce jusqu'à une profondeur typiquement comprise entre 200 et 500 nanomètres.

En première approche, si l'on considère que les défauts créés par les ions dans l'objet réalisé en un matériau au moins partiellement transparent sont de forme sensiblement cubique, la longueur d'un côté d'un tel cube est typiquement de l'ordre de 50 à 200 nanomètres. Bien entendu, la taille des défauts créés et la profondeur jusqu'à laquelle de tels défauts sont créés sont notamment fonctions de la nature du matériau dans lequel est réalisé l'objet, de la masse des ions, du degré d'ionisation des ions et de la vitesse avec laquelle les ions percutent la surface de l'objet. On comprend également que la taille des défauts créés dans l'objet va en décroissant depuis la surface vers l'intérieur de cet objet. Des analyses effectuées notamment par microscopie électronique par transmission révèlent qu'un objet réalisé en un matériau au moins partiellement transparent structuré au moyen d'un faisceau d'ions conformément au procédé selon l'invention présente, depuis la surface vers l'intérieur, une couche superficielle très mince, de l'ordre de 10 à 15 nanomètres, dépourvue de défauts, suivie d'une couche de structure amorphe dont l'épaisseur est comprise entre 100 et 500 nanomètres et dans laquelle se forment les défauts. Au-delà de cette couche de structure amorphe, on n'observe quasiment plus d'effet du bombardement ionique sur la structure de la matière dans laquelle est réalisé l'objet.

Parmi les techniques d'implantation ionique connues, l'une d'entre elles consiste à bombarder la surface de l'objet à traiter au moyen d'une source d'ions mono- ou multichargés du type à résonance cyclotron électronique. Une telle installation est encore connue sous sa dénomination anglo-saxonne Electron Cyclotron Resonance ou ECR.

Une source d'ions ECR fait usage de la résonance cyclotronique des électrons pour créer un plasma. Des micro-ondes sont injectées dans un volume de gaz à basse pression destiné à être ionisé, à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules et provoquent leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

### Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :
- la figure 1 est vue schématique d'une source d'ions mono- ou multichargés du type à résonance cyclotron électronique ECR selon l'art antérieur ;
- les figures 2A et 2B sont des vues en perspective qui illustrent les étapes du procédé selon l'invention permettant de structurer au moyen d'un faisceau d'ions multichargés un motif décoratif dans une surface d'un objet réalisé en un matériau au moins partiellement transparent ;
- la figure 3 est une vue en coupe à travers l'épaisseur d'un objet réalisé en saphir bombardé au moyen d'un faisceau d'ions azote ;
- la figure 4 est une vue en perspective d'une boîte de montre dans divers éléments de laquelle sont réalisés des motifs décoratifs conformément aux enseignements du procédé selon l'invention ;
- les figures 5A et 5B illustrent deux modes de réalisation différents d'éclairement d'un motif décoratif structuré dans la surface supérieure d'une glace de montre conformément au procédé selon l'invention ;
- la figure 6 illustre un masque réalisé sous la forme d'une feuille de métal dans laquelle a été découpée une ouverture dont le contour correspond au motif à structurer ;
- la figure 7A est une vue de dessous de la boîte de montre représentée à la figure 4 ;
- la figure 7B est une vue de dessus d'un cadran de montre dans lequel ont été structurés un motif décoratif ainsi que des index horaires qui forment des motifs techniques, et
- la figure 7C est une représentation d'un pont pour un mouvement d'horlogerie dans lequel un motif décoratif a été structuré par mise en oeuvre du procédé selon l'invention.

### Description détaillée d'un mode de réalisation de l'invention

La présente invention procède de l'idée générale inventive qui consiste à bombarder de manière sélective la surface d'un objet réalisé en un matériau au moins partiellement transparent au travers d'un masque à l'aide d'un faisceau d'ions mono- ou multichargés pour créer dans cet objet un motif technique ou décoratif tridimensionnel. On entend par faisceau d'ions mono-ou multichargés un faisceau comprenant des ions accélérés sous l'effet d'un champ électrique et présentant soit tous le même degré d'ionisation, soit présentant des degrés d'ionisation différents. Les ions frappent la surface de l'objet et pénètrent dans celui-ci jusqu'à une certaine profondeur, créant des défauts du type cavités ou lacunes dont les propriétés, notamment optiques, sont différentes de celles de la matière qui n'est pas affectée par le bombardement ionique. On comprend que la profondeur jusqu'à laquelle les ions pénètrent dans l'objet et les dimensions des défauts créés dépendent de multiples facteurs parmi lesquels on peut citer la nature du matériau dans lequel est réalisé l'objet au moins partiellement transparent, la masse des ions, le degré d'ionisation des ions ou bien encore la vitesse à laquelle les ions viennent frapper la surface de l'objet. On comprend également que les caractéristiques de ces défauts, à savoir leurs dimensions et la profondeur à laquelle ils se trouvent sous la surface de l'objet, déterminent leurs propriétés physiques, notamment optiques. Dans certains cas en effet, le motif technique ou décoratif tridimensionnel structuré dans l'objet réalisé en un matériau au moins partiellement transparent conformément au procédé selon l'invention n'est pas perceptible dans des conditions normales d'utilisation, et sa présence ne peut être révélée que si l'utilisateur exploite les propriétés hydrophiles du motif en projetant un peu de buée sur la surface de l'objet dans laquelle le motif a été structuré. Dans d'autres cas, les défauts qui forment le motif technique ou décoratif recherché agissent comme autant de centres de diffusion de la lumière, de sorte que le motif est perceptible même en conditions normales de luminosité, et ressort de façon encore beaucoup plus marquée lorsque l'objet dans lequel ce motif a été structuré est éclairé au moyen d'une source de lumière.

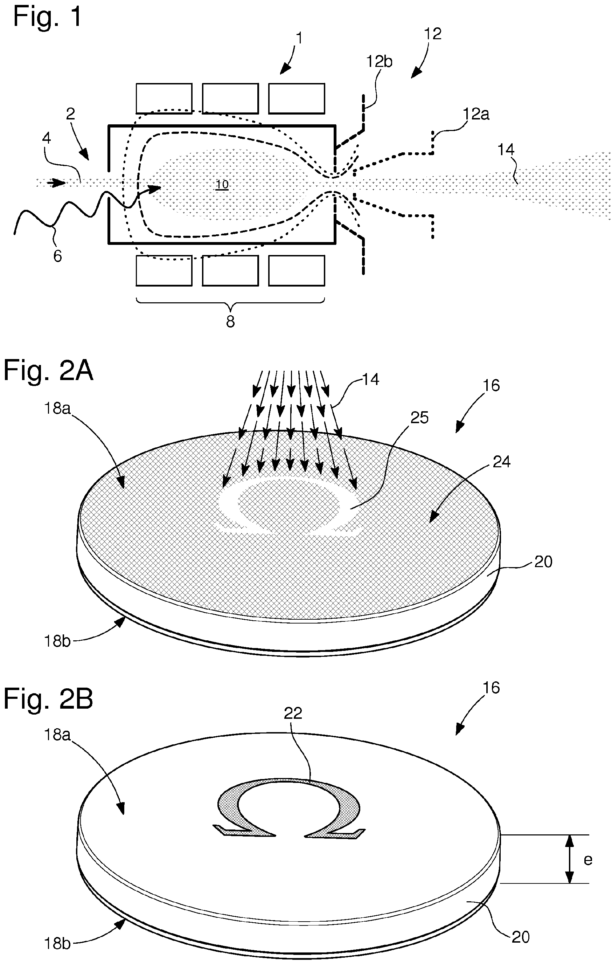

Il existe plusieurs techniques d'implantation ionique. Dans le cadre de la présente demande de brevet, on s'intéresse en particulier à une source d'ions mono- ou multichargés du type à résonance cyclotron électronique ECR. Très schématiquement, et comme illustré sur la figure 1 annexée à la présente demande de brevet, une source d'ions ECR, désignée dans son ensemble par la référence numérique générale 1, comprend un étage d'injection 2 dans lequel on introduit un volume 4 de gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 12a et d'une cathode 12b entre lesquelles est appliquée une haute tension. A sa sortie, la source d'ions ECR 1 produit un faisceau d'ions 14 qui, en fonction des besoins, pourra comprendre des ions présentant tous le même degré d'ionisation, ou bien résultera d'un mélange d'ions présentant des degrés d'ionisation différents. En première approche, la tension d'accélération des ions est comprise entre 1kV et 1000kV et la dose d'implantation est comprise entre 1.10¹⁵ions.cm⁻² et 10¹⁸ions.cm⁻².

Un exemple d'un objet réalisé en un matériau transparent cristallin et dans lequel est réalisé un motif décoratif conformément au procédé selon l'invention est illustré aux figures 2A et 2B. Désigné dans son ensemble par la référence numérique générale 16, cet objet est une glace réalisée en saphir et destinée à fermer une boîte de montre par le haut. Cette glace 16 comprend une surface supérieure 18a et une surface inférieure 18b qui s'étend à distance de la surface supérieure 18a et qui est reliée à cette dernière le long de son pourtour par une tranche 20. Dans l'exemple illustré aux figures 2A et 2B, on a choisi de structurer un motif décoratif 22, en l'occurrence la lettre de l'alphabet grec Ω, dans la surface supérieure 18a de la glace 16. Bien entendu, cet exemple est donné à titre illustratif et non limitatif seulement, étant entendu qu'il serait possible de structurer un motif dans la surface inférieure 18b de la glace 16, voire même de structurer un motif décoratif dans chacune des surfaces supérieure 18a et inférieure 18b de la glace 16.

A titre d'exemple uniquement, la glace 16 en saphir qui a été traitée conformément au procédé selon l'invention est plane. Ses surfaces supérieure 18a et inférieure 18b s'étendent parallèlement entre elles en étant séparées par une épaisseur e = 2 mm. Après masquage de la surface supérieure 18a de la glace 16 au moyen d'un masque 24 afin de délimiter une ouverture 25 dont le contour corresponde au motif décoratif 22 recherché, on bombarde la glace 16 au moyen d'un faisceau d'ions 14 constitué d'ions azote de degré d'ionisation +1 à +3. Le faisceau d'ions 14 est produit au moyen d'une source d'ions ECR 1 du type décrit ci-dessus en liaison avec la figure 1. La tension d'accélération des ions utilisée est de 37,5kV et la dose d'implantation ionique est de 0,5*10¹⁶ions.cm⁻². On constate que, dans les conditions expérimentales détaillées ci-avant, le motif décoratif 22 est imperceptible dans les conditions de luminosité ambiante naturelle, et sa présence ne peut être révélée que si l'utilisateur souffle de la buée en direction de la surface supérieure 18a de la glace 16. De l'avis de la Demanderesse, ce phénomène s'explique par le fait que la zone de la glace 16 dans laquelle est structuré le motif décoratif 22 présente un comportement hydrophile. Ainsi, lorsque la buée tombe sur la surface supérieure 18a de la glace 16, il se forme une couche d'eau plus mince et avec une tension superficielle moins élevée dans la zone hydrophile où le motif décoratif 22 a été structuré que sur le reste de la surface supérieure 18a. La couche d'eau à l'endroit où le motif décoratif 22 a été structuré est donc optiquement moins diffusive et devient donc perceptible par l'utilisateur.

Un second exemple de mise en oeuvre du procédé selon l'invention est donné en liaison avec une glace 16 identique à celle décrite ci-dessus. Le motif décoratif 22 structuré dans la surface supérieure 18a de la glace 16 est lui aussi inchangé, seuls les paramètres du bombardement ionique étant modifiés. En l'occurrence, la glace 16 est bombardée au moyen d'un faisceau d'ions 14 constitué d'ions azote de degré d'ionisation +1 à +3. Le faisceau d'ions 14 est produit au moyen d'une source d'ions ECR 1 du type décrit ci-dessus en liaison avec la figure 1. La tension d'accélération des ions utilisée est de 37.5kV et la dose d'implantation ionique est de 1.10¹⁷ions.cm⁻². On constate que, dans les conditions expérimentales détaillées ci-avant, le motif décoratif 22 structuré dans la glace 16 est visible à l'oeil nu à la lumière du jour, et ressort de façon encore beaucoup plus marquée lorsque la glace 16 dans laquelle ce motif décoratif 22 a été structuré est éclairé au moyen d'une source de lumière. On comprend que les défauts qui forment le motif décoratif 22 agissent comme autant de centres de diffusion de la lumière, de sorte que le motif décoratif 22 est perceptible même en conditions normales de luminosité.

Dans les deux exemples détaillés ci-dessus, on voit qu'en utilisant les mêmes ions et en les accélérant avec une même tension, il est possible, en variant uniquement la dose d'ions implantée, de modifier les propriétés physiques, notamment optiques, du motif décoratif 22 obtenu. En effet, avec une dose d'implantation ionique de 0,5*10¹⁶ions.cm⁻², le motif décoratif 22 est imperceptible à l'oeil nu dans des conditions d'éclairement normales, et sa présence est révélée par projection de buée pour exploiter ses propriétés hydrophiles. Dans le second cas, la dose d'implantation ionique est de 1*10¹⁷ions.cm⁻² et permet de créer dans la glace 16 des défauts qui agissent comme des centres de diffusion de la lumière, rendant le motif décoratif 22 perceptible même à la lumière du jour. Ces différences de comportement physique du motif structuré dans l'objet réalisé en un matériau au moins partiellement transparent s'expliquent par le fait que les défauts qui apparaissent dans l'objet sous l'effet du bombardement ionique diffèrent par leurs dimensions et par leur concentration par unité de volume.

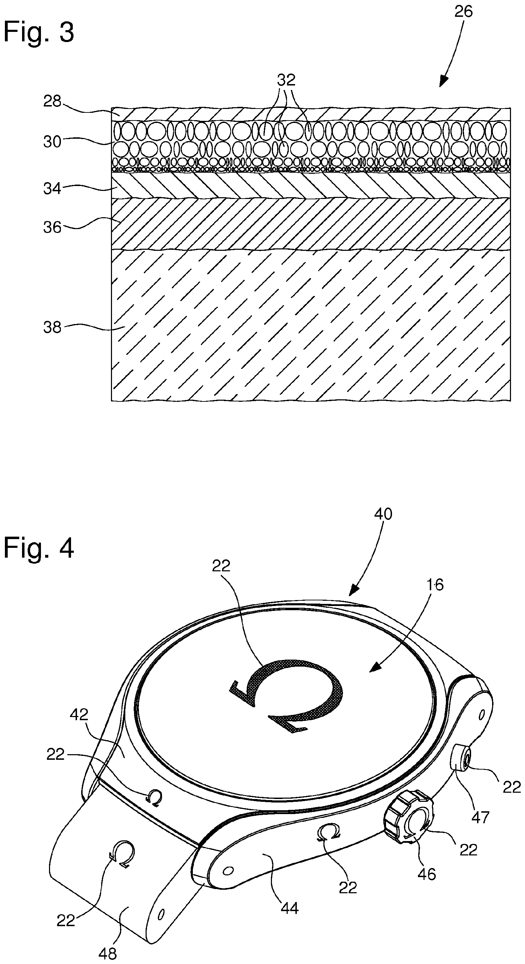

La figure 3 est une vue en coupe dans l'épaisseur d'un échantillon de saphir 26 bombardé au moyen d'un faisceau d'ions azote. En examinant cette figure, on constate que l'échantillon de saphir 26 présente, depuis la surface vers l'intérieur, la succession de couches suivante :
- d'abord une couche superficielle 28, très mince, typiquement de l'ordre de 7 à 15 nanomètres qui, de manière surprenante, est peu ou pas affectée par le bombardement ionique et conserve sa structure cristalline. Une tentative pour expliquer ce phénomène est que, lorsque les ions azote viennent frapper la surface de l'échantillon de saphir 26, les ions azote pénètrent dans l'échantillon de saphir 26 en empruntant le chemin de plus faible énergie et passent à travers les mailles de la structure cristallographique du silicium.
- ensuite, une première couche amorphe 30 dont l'épaisseur est typiquement comprise entre 50 et 60 nanomètres. Cette première couche amorphe 30 se caractérise par des cavités 32 dont les dimensions vont en diminuant au fur et à mesure que les ions azote pénètrent plus profondément dans l'épaisseur de l'échantillon de saphir 26. Ce phénomène s'explique par le fait que plus les ions azote pénètrent profondément dans l'épaisseur de l'échantillon de saphir 26, moins leur vitesse est grande et moins importants sont les dégâts qu'ils occasionnent à la structure cristallographique de l'échantillon de saphir 26.
- ensuite, une seconde couche amorphe 34 dépourvue de cavités dont l'épaisseur est de l'ordre de 20 à 30 nanomètres. La structure cristallographique du saphir est donc très perturbée par le bombardement ionique jusqu'à une profondeur d'environ 80 à 100nm sous la surface de l'échantillon de saphir 26.

- enfin, une dernière couche 36 d'une épaisseur de l'ordre de 50 à 60 nanomètres dont la cristallinité est perturbée sans toutefois que le saphir soit rendu amorphe dans tout son volume.
- au-delà de cette dernière couche 36, on retrouve le saphir dans son volume 38.

Sur la figure 4, on a représenté à titre d'exemple uniquement une boîte de montre 40 dont certains composants ont été traités conformément au procédé selon l'invention. Il s'agit d'une lunette 42, d'une carrure 44, d'une couronne 46, d'un correcteur 47 et d'un maillon 48 pour un bracelet de montre. Ces divers éléments sont réalisés conformément au procédé selon l'invention au moyen d'un objet réalisé en un matériau au moins partiellement transparent dont la structure est cristalline, semi-cristalline ou bien amorphe et dans lequel on grave le motif décoratif 22 au moyen d'un faisceau d'ions mono- ou multichargés.

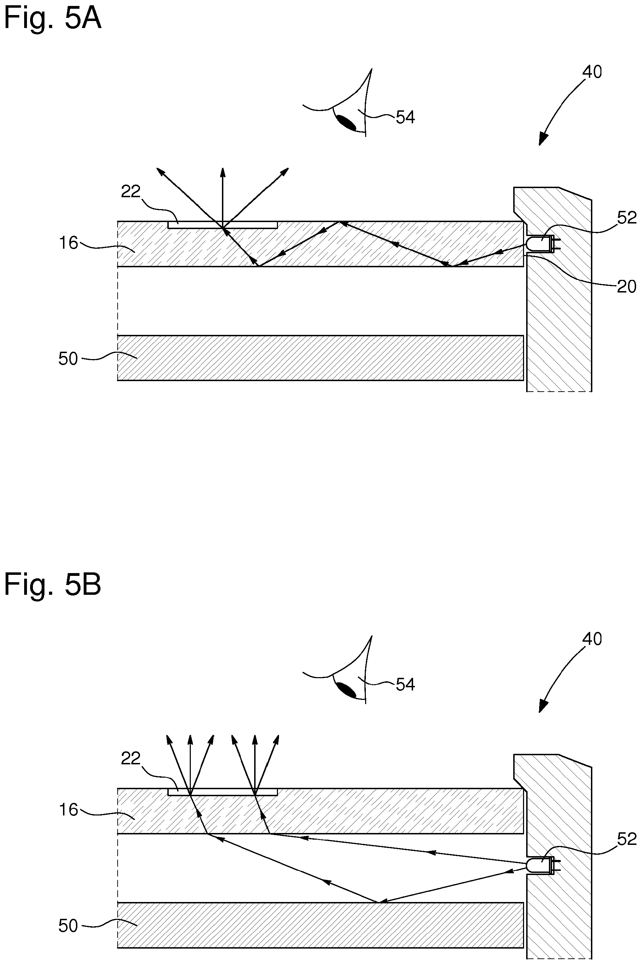

La glace 16 munie de son motif décoratif 22 décrite ci-dessus s'étend au-dessus d'un cadran 50 et ferme par le haut la boîte de montre 40 (voit figures 5A et 5B). Il s'agit de la variante dans laquelle les défauts créés par le bombardement ionique forment un motif décoratif 22 qui diffuse la lumière. Pour mettre ce motif décoratif 22 plus en valeur encore, il est prévu d'éclairer la glace 16 au moyen d'une source de lumière 52. Cette source de lumière 52 peut être disposée en regard de la tranche 20 de la glace 16. La lumière produite par la source de lumière 52 pénètre ainsi dans l'épaisseur de la glace 16 et une partie est extraite de la glace 16 par le haut en direction de l'observateur 54 en étant diffusée par les défauts qui forment le motif décoratif 22, ce qui rend le motif décoratif 22 lumineux et très visible. La source de lumière 52 peut également être disposée entre le cadran 50 et la glace 16. La lumière produite par la source de lumière 52 pénètre dans la glace 16 soit directement, soit en se réfléchissant tout d'abord sur le cadran 50, puis est diffusée en partie vers l'extérieur de la boîte de montre 40 par les défauts qui forment le motif décoratif 22, rendant ce motif décoratif 22 parfaitement visible.

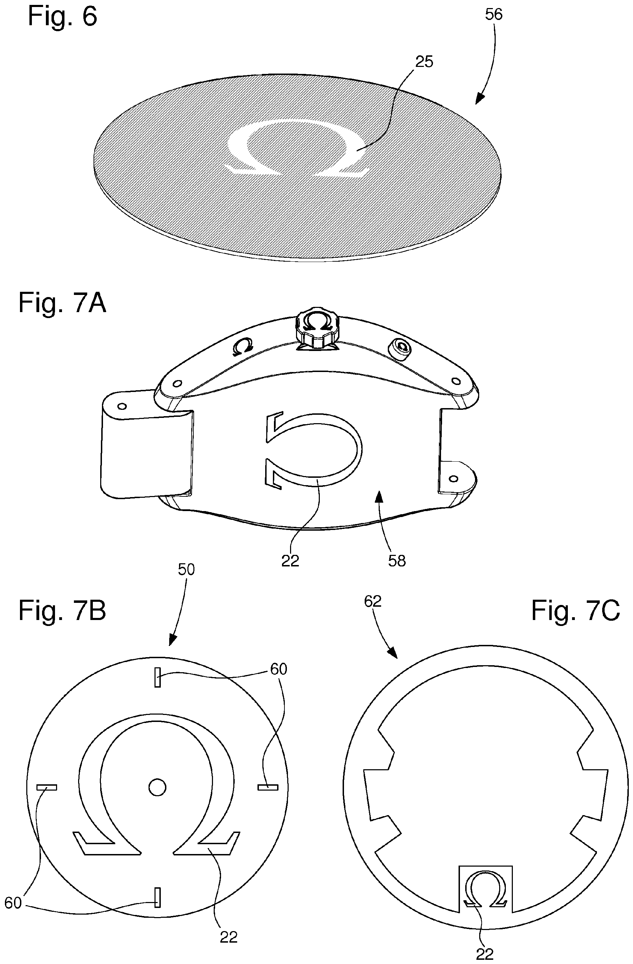

La figure 6 illustre un masque réalisé sous la forme d'une feuille de métal 56 dans laquelle a été découpée une ouverture 25 dont le contour correspond au motif décoratif 22 à structurer.

La figure 7A est une vue de dessous de la boîte de montre 40 représentée à la figure 4. Cette boîte de montre 40 est fermée par un fond 58 réalisé en un matériau cristallin, semi-cristallin ou amorphe au moins partiellement transparent dans lequel est structuré un motif décoratif 22 conformément au procédé selon l'invention.

La figure 7B est une vue de dessus du cadran de montre 50 dans lequel a été structuré un motif décoratif 22 conformément au procédé selon l'invention. En appliquant le procédé selon l'invention, on a également structuré dans le cadran 50 des motifs techniques 60, en l'occurrence quatre index horaires à midi, trois heures, six heures et neuf heures.

La figure 7C est une représentation d'un pont 62 pour un mouvement d'horlogerie dans lequel un motif décoratif 22 a été structuré par mise en oeuvre du procédé selon l'invention.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées.

On notera en particulier que le masque peut se présenter sous la forme d'une feuille de métal dans laquelle le contour du motif à structurer a été découpé, cette feuille de métal étant ensuite fixée sur celle des surfaces de l'objet dans laquelle on souhaite structurer le motif. De la même manière, le masque pourrait également être réalisé en céramique. Le masque peut aussi être obtenu par dépôt sélectif tel que l'impression par jet d'encre d'un matériau de masquage aux endroits où le masque doit recouvrir celle des surfaces supérieure et/ou inférieure dans laquelle on veut structurer le motif. Le masque peut aussi être obtenu par dépôt d'une couche d'un matériau de masquage sur la totalité de celle des surfaces supérieure et/ou inférieure de l'objet dans laquelle on veut structurer le motif. Cette couche de masquage est ensuite ablatée aux endroits où l'on veut structurer le motif dans l'épaisseur de l'objet, par exemple au moyen d'un faisceau laser. Le masque peut aussi être réalisé au moyen d'une couche de résine sensible à la lumière, par exemple au rayonnement ultraviolet, et être structuré au moyen d'une source de lumière par exemple ultraviolette. Dans tous les cas, le masque doit présenter des propriétés mécaniques telles que le faisceau d'ions ne parvienne pas à attaquer la surface de l'objet réalisé en un matériau au moins partiellement transparent dans lequel le motif doit être structuré aux endroits où l'objet est recouvert par le masque.

Par matériau transparent, on entend un matériau qui, se laissant aisément traverser par la lumière, permet de distinguer nettement les objets à travers son épaisseur.

Par objet réalisé en un matériau au moins partiellement transparent, on entend un objet réalisé en un bloc de matériau qui présente au moins une zone transparente dans laquelle on va venir structurer le motif technique ou décoratif conformément au procédé selon l'invention, les autres zones de l'objet pouvant quant à elles être opaques.

Par verre on entend un solide non cristallin qui présente le phénomène de transition vitreuse.

Le matériau au moins partiellement transparent dans lequel est réalisé l'objet dans lequel est structuré le motif technique ou décoratif conformément au procédé selon l'invention peut être au choix cristallin, semi-cristallin ou amorphe. Parmi les matériaux cristallins qui sont bien adaptés aux besoins de l'invention, on peut citer le saphir, le rubis ou le diamant. On peut envisager d'utiliser la forme naturelle de ces pierres, mais on comprendra que l'utilisation de saphir, de rubis ou de diamant obtenu par synthèse est plus réaliste dans un contexte de production industrielle. Dans le domaine des matériaux amorphes, un exemple de matériau bien adapté aux besoins de l'invention est donné par le verre minéral. D'autres exemples de matériaux semi-cristallins ou amorphes qui conviennent bien pour la mise en oeuvre du procédé selon l'invention sont donnés par le polypropylène homo, le polypropylène copolymère et le polyéthylène téréphtalate qui sont des matériaux thermoplastiques transparents semi-cristallins, ainsi que par le polystyrène cristal et le polyméthacrylate de méthyle qui sont des matériaux thermoplastiques transparents amorphes.

### Nomenclature

1. Source d'ions ECR
2. Etage d'injection
4. Volume de gaz à ioniser
6. Onde hyperfréquence
8. Etage de confinement magnétique
10. Plasma
12. Etage d'extraction
12a. Anode
12b. Cathode
14. Faisceau d'ions
16. Glace
18a. Surface supérieure
18b. Surface inférieure
20. Tranche
22. Motif décoratif
e. Epaisseur
24. Masque
25. Ouverture
26. Echantillon de saphir
28. Couche superficielle
30. Première couche amorphe
32. Cavités
34. Seconde couche amorphe
36. Dernière couche
38. Volume
40. Boîte de montre
42. Lunette
44. Carrure
46. Couronne
47. Correcteur
48. Maillon
50. Cadran
52. Source de lumière
54. Observateur
56. Feuille de métal
58. Fond
60. Motif technique
62. Pont

## Revendications

1. Procédé de structuration d'un motif décoratif ou technique (22, 60) dans l'épaisseur d'un objet réalisé en un matériau amorphe, semi-cristallin ou cristallin au moins partiellement transparent, l'objet réalisé en un matériau au moins partiellement transparent comprenant une surface supérieure (18a) et une surface inférieure (18b) qui s'étend à distance de la surface supérieure (18a), le procédé comprenant l'étape qui consiste à munir l'une au moins des surfaces supérieure (18a) ou inférieure (18b) de l'objet réalisé en un matériau au moins partiellement transparent d'un masque (24) qui définit au moins une ouverture (25) dont le contour correspond au profil du motif décoratif ou technique (22, 60) que l'on souhaite structurer, le masque (24) recouvrant la au moins une surface supérieure (18a) ou inférieure (18b) de l'objet réalisé en un matériau au moins partiellement transparent aux endroits qui ne doivent pas être structurés, le procédé comprenant également l'étape qui consiste à structurer le motif décoratif ou technique (22, 60) au moyen d'un faisceau d'ions (14) mono- ou multichargés à travers la au moins une ouverture (25) du masque (24), les propriétés mécaniques du masque (24) étant suffisantes pour empêcher les ions du faisceau d'ions (14) d'attaquer la au moins une surface supérieure (18a) ou inférieure (18b) de l'objet réalisé en un matériau au moins partiellement transparent aux endroits où cette surface supérieure (18a) ou inférieure (18b) est recouverte par le masque (24).

2. Procédé selon la revendication 1, **caractérisé en ce que** le faisceau d'ions (14) mono- ou multichargés est produit par une source d'ions (1) mono- ou multichargés à résonance cyclotron électronique ECR.

3. Procédé selon l'une des revendications 1 et 2, **caractérisé en ce que** l'objet au moins partiellement transparent est réalisé en saphir, en rubis ou en diamant naturel ou de synthèse.

4. Procédé selon l'une des revendications 1 et 2, **caractérisé en ce que** l'objet au moins partiellement transparent est réalisé en un matériau organique semi-cristallin.

5. Procédé selon l'une des revendications 1 et 2, **caractérisé en ce que** l'objet au moins partiellement transparent est réalisé en verre minéral ou en un matériau organique amorphe.

6. Procédé selon l'une des revendications 1 à 5, **caractérisé en ce que** le masque (24) est une feuille de matériau dans laquelle le contour du motif décoratif ou technique (22, 60) a été découpé, cette feuille de matériau étant ensuite fixée sur celle des surfaces supérieure (18a) et/ou inférieure (18b) de l'objet dans laquelle on souhaite structurer le motif (22, 60).

7. Procédé selon la revendication 6, **caractérisé en ce que** le masque (24) est réalisé en métal ou en céramique.

8. Procédé selon l'une des revendications 1 à 5, **caractérisé en ce que** le masque (24) est obtenu par dépôt sélectif d'un matériau de masquage aux endroits où le masque (24) doit recouvrir celle des surfaces supérieure (18a) et/ou inférieure (18b) aux endroits où cette surface supérieure (18a) et/ou inférieure (18b) ne doit pas être frappée par le faisceau d'ions (14).

9. Procédé selon la revendication 8, **caractérisé en ce que** le masque est réalisé par impression par jet d'encre.

10. Procédé selon l'une des revendications 1 à 5, **caractérisé en ce que** le masque (24) est obtenu par dépôt d'une couche d'un matériau de masquage sur celle des surfaces supérieure (18a) et/ou inférieure (18b) sur laquelle le masque (24) doit être structuré, puis ablation de la couche de masquage aux endroits où celle des surfaces supérieure (18a) et/ou inférieure (18b) doit être structurée.

11. Procédé selon la revendication 10, **caractérisé en ce que** la couche de matériau de masquage est ablatée au moyen d'un faisceau laser.

12. Procédé selon la revendication 10, **caractérisé en ce que** le matériau de masquage est une résine sensible au rayonnement ultraviolet qui est structurée au moyen d'une source UV.

13. Objet obtenu par la mise en oeuvre du procédé selon l'une des revendications 1 à 12.

14. Objet selon la revendication 13, **caractérisé en ce qu'**il s'agit :
• d'une glace (16), d'un cadran (60) ou d'une lunette (42) pour une pièce d'horlogerie telle qu'une montre-bracelet ;
• d'une carrure (44) ou d'un fond (58) de boîte de montre (40) ;
• d'une couronne (46), d'une tête de correcteur (47) ou d'un pont (64) pour un mouvement d'horlogerie, ou bien encore
• d'un maillon (48) de bracelet pour une montre ou un bijou.

15. Objet portable, notamment une boîte de montre (40), comprenant au moins un élément choisi dans le groupe formé par une glace (16), un cadran (60), une lunette (42), une carrure (44), un fond (58), une couronne (46), une tête de correcteur (47), un pont (64) et un maillon de bracelet (48), ce au moins un élément étant réalisé en un matériau amorphe, semi-cristallin ou cristallin au moins partiellement transparent et structuré conformément au procédé selon l'une quelconque des revendications 1 à 11, cet élément comprenant au moins une surface supérieure et au moins une surface inférieure reliées entre elles par une tranche, l'objet portable comprenant également une source de lumière (52), la source de lumière (52) étant agencée de façon à éclairer l'élément par sa surface inférieure ou par sa tranche.
